# EUROPÄISCHE PATENTANMELDUNG

(11) **EP 3 923 321 A1**
(43) Veröffentlichungstag der Anmeldung: **15.12.2021**
(21) Anmeldenummer: 20178790.0
(22) Anmeldetag: 08.06.2020
(51) Int. Cl.: H01L 23/498

(54) **MODUL MIT ANSCHLUSSLASCHEN FÜR ZULEITUNGEN**

(71) Anmelder: CeramTec GmbH, 73207 Plochingen (DE)
(72) Erfinder: THIMM, Alfred, 95632 Wunsiedel (DE); KREß, Harald, 90579 Langenzenn (DE)

(57) **Zusammenfassung**

Die Erfindung betrifft ein Modul (1), bei dem Spannungen größer als 1.000 V und Ströme größer als 100 A über Zuleitungen angelegt werden, mit einem elektrisch isolierenden Träger (2), mit einem Anschlussmittel (3) mit einer Materialdicke größer als 0,3 mm, welches über einen Metallisierungsbereich (4), der von einem ersten Ende (23) und einem zweiten Ende (24) begrenzt ist, mit dem Träger (2) verbunden ist, mit elektronischen Komponenten (19, 20), die mit dem Anschlussmittel (3) je nach Bedarf elektrisch verbunden sind und mit Kühlmittel (14).

Damit die Stromzuführung von außen über das Anschlussmittel (3) direkt an das Modul erfolgt und somit die im Stand der Technik üblichen Bondprozesse entfallen und dadurch parasitäre Induktivitäten an der Stromzuführung vermieden werden, wird erfindungsgemäß vorgeschlagen, dass das Anschlussmittel (3) an zumindest einer Stelle über ein Ende (23, 24) des Metallisierungsbereichs (4) ragt, und in diesem Bereich (9) nicht mit dem Träger (2) fixiert ist und Kontaktmittel (22) aufweist.

## Beschreibung

Die Erfindung betrifft ein Modul im Bereich der Leistungselektronik, welches Spannungen größer als 1.000 V und Ströme größer als 100 A steuern kann. Das Modul umfasst wenigstens
- einen elektrisch isolierenden Träger, mit wenigstens einem Anschlussmittel, das über einen Metallisierungsbereich mit dem Träger verbunden ist, wobei das Anschlussmittel vorzugsweise aus Kupfer gebildet ist und eine Materialdicke aufweist, die größer als 0,3 mm ist,
- eine elektronische Komponente die an dem Träger angeordnet und mit dem Anschlussmittel elektrisch verbunden ist, um die zugeführte Leistung zu steuern und
- ein Kühlelement, welches dazu geeignet ist Wärme abzuleiten.

Es sind Bipolartransistoren mit isolierter Gate-Elektrode (IGBT) bekannt, welche als Halbleiterbauelement in der Leistungselektronik verwendet werden. An diese IGBT-Module werden Spannungen größer als 1.000 V und Ströme größer als 100 A über Zuleitungen angelegt.

Die im Stand der Technik bekannten Module umfassen ein plattenförmiges Substrat, beispielsweise eine gesinterte Keramik, das eine Vorder- und Rückseite aufweist. Zur Kühlung des Moduls ist auf der Rückseite ein metallischer Kühler angeordnet. Auf der Vorderseite des Substrats ist ein Metallisierungsbereich bestehend aus Kupfer mit einer Materialdicke zwischen 0,3 mm und 1,0 mm vorgesehen. Die Verbindung zwischen dem Kupfer und einer außerhalb des Moduls vorhandenen Strom- und Spannungsversorgung erfolgt mittels sogenannten Bonddrähten. Um sicherzustellen, dass die hohen Spannungen und Ströme in das Modul geleitet werden können, ist eine Vielzahl von Bonddrähten erforderlich. Diese Bonddrähte sind teilweise im geringen Abstand zueinander und unter einer Krümmung, um Temperaturschwankungen auszugleichen, angeordnet. Dadurch können sich sogenannte parasitäre Induktivitäten bilden. Bekannte Verfahren, um den Metallisierungsbereich mit dem Substrat zu verbinden sind DCB "Direct copper bonded" oder AMB "Active Metal Brazing".

Das DCB-Verfahren, ist eine Verbindungstechnik, bei der in einem hohen Temperaturbereich von 1060 bis 1065 °C Kupfer mit einem keramischen Substrat verbunden werden kann. Dazu wird das Kuper nahe seines Schmelzpunktes 1085°C erwärmt. Das Kupfer erreicht dabei den Bereich der Erweichungstemperatur, was seine Eigenschaften und Dimensionsstabilität in diesem Prozessschritt beeinflusst. Beim DCB-Verfahren können Hohlräume, sogenannte Lunker zwischen der Keramik und dem Kupfer entstehen. Diese Hohlräume beeinflussen den Wärmeübergang nachteilig und fördern die Teilentladung, was unter Sicherheitsaspekten ein Risiko bedeuten kann. Das DCB-Verfahren wird verwendet bei der Metallisierung von sogenannten Master-Karten der Größe 7,5" x 5,5". Eine Master-Karte kann mehrere Substrate mit geringerer Ausdehnung umfassen, die entsprechend ihren Anwendungen vereinzelt werden. Mit dem DCB-Verfahren können Verbunde aus Kupfer und Keramik hergestellt werden. Abhängig von der verwendeten Keramik sind diese Verbunde für 100 bis 1.000 Lastwechsel geeignet.

Unter dem AMB-Verfahren wird das "Active Metal Brazing", d.h. das aktive Hartlöten, das Verbinden von beispielsweise Metall mit Keramik, verstanden. Dabei wird in einem Vakuum oder einer Inertgasatmosphäre, mittels einer Metalllotlegierung, Kupfer mit Keramik, beispielsweise AlSiC verbunden. Bei dem AMB-Verfahren handelt es sich aufgrund der Prozessbedingungen, Vakuum oder Inertgasatmosphäre, um einen kostenintensiven Prozess. Trotzdem hat er sich in der industriellen Herstellung von gekühlten Leistungsmodulen etabliert, da abhängig von den verwendeten Materialien Verbunde hergestellt werden, die für bis zu 5.000 Lastwechsel geeignet sind.

Der Erfindung liegt die Aufgabe zugrunde die Performance eines Moduls in der Leistungselektronik so zu verbessern, dass bei einer hohen Anzahl von Lastwechseln, dauerhaft eine störungsfreie elektronische Funktionsweise, bei einer kompakten Form, sichergestellt ist.

Erfindungsgemäß wird diese Aufgabe durch ein Modul mit den Merkmalen des Anspruchs 1 gelöst.

Ein erfindungsgemäßes Modul weist einen Träger, vorzugsweise einen keramischen Träger auf, an dem auf einer ersten Flachseite ein Anschlussmittel angeordnet ist. Dieses Anschlussmittel ist vorzugsweise aus Kupfer gebildet und stellt die Verbindung zu einer externen Strom- bzw. Spannungsquelle dar. Das Anschlussmittel kann in Form einer Leitungsschiene oder eines BUS-Bars gebildet sein und ist über einen Metallisierungsbereich mit dem Träger verbunden. Erfindungsgemäß dehnt sich das Anschlussmittel über die geometrischen Maße des Metallisierungsbereiches und/ oder des Trägers hinaus aus, es überragt den Metallisierungsbereich und/ oder Träger. Mit anderen Worten, das Anschlussmittel überragt den Träger und/oder den Metallisierungsbereich an wenigsten einer Stelle in seitlicher Richtung. Unter einer Stelle kann eine Position, und/oder ein Bereich, beispielsweise eine Seitenfläche, und/oder ein Teilbereich einer Seitenfläche und/oder ein Abschnitt/ Bereichs des Umfangs verstanden werden. Weist der Träger und/oder der Metallisierungsbereich beispielsweise die Form eines Quaders auf mit den Abmessungen L x B x H ist erfindungsgemäß ein Bereich bzw. ein Abschnitt des Anschlussmittels außerhalb dieses Quaders angeordnet. Dies bedeutet, ein erstes Ende des Anschlussmittels ist außerhalb des Trägers und/oder des Metallisierungsbereichs angeordnet, während ein zweites Ende des Anschlussmittels im Bereich der ersten Flachseite des Trägers und/oder des Metallisierungsbereichs angeordnet ist.

Das Anschlussmittel ist mittels einer Metallisierung mit dem Träger stoffschlüssig verbunden. Um eine sichere Verbindung zwischen dem Träger und dem Anschlussmittel zu gewährleiten wurde überraschenderweise festgestellt, dass es ausreichend ist, wenn das Anschlussmittel nur in einem Teilbereich mittels der Metallisierung mit dem Träger verbunden wird. Für eine sichere Funktionsweise ist es ausreichend, wenn ungefähr 66% der Grundfläche des Anschlussmittels mittels der Metallisierung mit dem Träger verbunden ist. Dies bedeutet, ungefähr 33% der Grundfläche des Anschlussmittels sind außerhalb des Trägers, des Leistungsmoduls bzw. außerhalb des Metallisierungsbereichs angeordnet und bilden zum Träger und/oder Metallisierungsbereichs einen Überstand. Mit anderen Worten, ist das Anschlussmittel in Form eines Quaders mit L x B x H gebildet, so ist die sichere Verbindung zwischen Anschlussmittel und Träger gewährleistet, wenn 66% der Grundfläche des Anschlussmittels, die sich aus L x B ergibt, mit dem Träger verbunden ist. Ein geeigneter Verbindungsprozess ist AMB. Im Bereich des Überstands kann das Anschlussmittel auf dem Träger aufliegen und auf diesem bei Wärmeausdehnung gleiten.

Das Anschlussmittel weist an seinem ersten Ende wenigstens ein Kontaktelement auf, an die die Strom- bzw. Spannungsquelle angeschlossen werden kann. Das Kontaktelement kann als eine Verlängerung des Anschlussmittels gebildet sein und ist dann in derselben Ebene wie das Anschlussmittel angeordnet. Löt- oder Schweißvorgänge zur Befestigung der Zuleitungen erfolgen dadurch thermisch entfernt vom Träger. Dadurch wird der Einfluss des Befestigungsprozesses der Leistungsversorgung auf das Modul reduziert, idealerweise ganz verhindert.

Bei einem alternativen Ausführungsbeispiel kann das Kontaktelement in einem Winkel zum Anschlussmittel geformt sein. Kontaktelement und Anschlussmittel weisen dann beispielsweise eine L-Form auf. Andere Formen beispielsweise U-Form, T-Form, etc. sind, abhängig vom Anschlussmittel der Strom- und Spannungsversorgung, möglich.

Zwischen dem ersten und dem zweiten Ende des Anschlussmittels kann eine thermische Entlastungszone in Form eines Dehnungsmittels vorgesehen sein. Das zumindest eine Dehnungsmittel kann außerhalb des Trägers und/oder des Metallisierungsbereichs, bevorzugt unmittelbar angrenzend an diesen angeordnet sein. Das Dehnungsmittel kompensiert die Wärmeausdehnungsdifferenzen zwischen dem Anschlussmittel und dem Träger und/oder der erwärmten Metallisierung unter den elektronischen Bauteilen, wie z.B. einem Chip. Dadurch wird die mechanische Belastung des Leistungsmoduls, die aufgrund der Wärmeentwicklung entsteht reduziert, vorzugsweise ganz verhindert.

Das Dehnungsmittel kann ein integraler Teil des Anschlussmittels sein und beispielsweise in Form eines gebogenen oder gewinkelten Abschnitts, einer Sicke, einer Rundung, einer Biegung, etc. ausgebildet sein. Der Querschnitt des Dehnungsmittels kann gleich oder geringer sein als der Querschnitt des Anschlussmittels.

Bei einer speziellen Ausführungsform kann das Dehnungsmittel einen Querschnitt aufweisen der geringer ist als der Querschnitt des Anschlussmittels. Dadurch wird die Flexibilität des Dehnungsmittels erhöht. Das Dehnungsmittel kann auch eine oder mehrere Aussparungen aufweisen. Die Aussparung kann in Form einer Öffnung mit einem Boden oder in Form einer Durchgangsöffnung gebildet sein. Umfasst das Dehnungsmittel mehrere in einer Reihe angeordnete Durchgangsöffnungen ist es in Form einer Perforation ausgebildet.

Die Form der Aussparung bzw. der Öffnung kann beliebig, beispielsweise rund oder quadratisch oder rechteckig oder eine Kombination aus diesen Formen gebildet sein. Das Anschlussmittel kann das Dehnungsmittel aufweisen, bevor es mit dem Träger verbunden wird.

Unabhängig der Form des Dehnungsmittels kann sich dies über die gesamte Breite oder alternativ nur über einen Teilbereich der Breite des Anschlussmittels erstrecken. Die Ausbildung des Dehnungsmittels ist an die Wärmeentwicklung bei der Leistungseinspeisung angepasst. Es kompensiert die Ausdehnung des Anschlussmittels und erhöht somit die Lebensdauer eines erfindungsgemäßen Moduls.

Dadurch, dass das Anschlussmittel an zumindest einer Stelle seitlich oder in einem Winkel über den Metallisierungsbereich hinausgeführt ist, in diesem Bereich nicht auf dem Träger fixiert ist und Kontaktelemente für eine Zuleitungen aufweist, vereinfacht sich die Verbindung der externen Stromzuführung zum Modul. Aufwendig herzustellende Bondprozesse sind nicht mehr erforderlich und entfallen. Zusätzlich werden dadurch parasitäre Induktivitäten an der Stromzuführung vermieden. Ein weiterer Vorteil der erfindungsgemäßen, direkten Anschlussmöglichkeit der Leistungseinspeisung in das Modul ist die dadurch reduzierte Bauhöhe. Die im Stand der Technik erforderlichen gebogenen Bonddrähte entfallen. Deshalb ist die Bauhöhe der Hochleistungsschaltung um die Ausdehnung der Bonddrähte über die elektronischen Komponenten hinweg verringert. Eine Miniaturisierung in der Leistungselektronik, eine geringere Bauhöhe, ist eine ständige Herausforderung bei der Entwicklung von Komponenten in der Leistungselektronik.

In einer erfindungsgemäßen Ausführungsform überragt das Anschlussmittel an der zumindest einen Stelle seitlich oder in einem Winkel den Metallisierungsbereich und weist ein Kontaktelement auf, welches den Träger nicht überragt. Dies bedeutet, dass sich bei dieser Ausführungsform das Anschlussmittel im Bereich des Trägers befindet, jedoch in einem Teilbereich nicht auf ihn fixiert, beispielsweise stoffschlüssig verbunden ist. Es kann aber auf dem Träger aufliegen und auf diesem bei Wärmeausdehnung gleiten. Diese spezielle Ausführungsform eignet sich für Anwendungen, bei denen auch seitlich neben dem Träger nur wenig Raum zur Verfügung steht.

Bei einer alternativen Ausführungsform kann das Anschlussmittel an allen Seiten, die das Anschlussmittel begrenzen, also am gesamten Umfang, über den Metallisierungsbereich ragen und trotzdem innerhalb der Abmaße des Trägers angeordnet sein.

Die erfindungsgemäßen Module, können zum Schutz vor äußeren Einwirkungen, mit einer elektrisch nichtleitenden Masse (z.B. Silikonmassen, wie im Stand der Technik bekannt, mit Ausnahme, der nach Außen führenden Kontaktmittel vergossen werden.

Entsprechend der Anwendung eines Moduls wird eine an sich bekannte Befestigungsmethode gewählt. Beispielsweise wird die externe Leistungsquelle über Befestigungen wie Löten, Klemmen, Crimpen, Verschrauben mit dem Kontaktelement elektrisch verbunden. Es können auch Steckverbindungen verwendet werden.

Bevorzugt ist der elektrisch isolierende Träger eine gesinterte Keramik. Um ein Leistungsmodul in hoher Qualität und langer Lebensdauer herzustellen eignet sich Aluminiumoxid- oder Aluminiumnitrid-Keramik sehr gut. Diese zeichnet sich durch ihre exzellente Wärmeleitfähigkeit in Verbindung mit der elektrisch isolierenden Eigenschaft aus.

Zur Kühlung des Moduls weist der Träger bevorzugt Kühlmittel auf. Diese können beispielweise in Form von Finnen zur Luftkühlung an der zweiten Flachseite des Trägers angeordnet sein. Um die thermische Ankopplung der Finnen mit dem Träger zu optimieren sind die Finnen vorzugsweise einstückig mit dem Träger verbunden. Mit anderen Worten, die Kühlmittel und der Träger bilden ein Teil und werden zusammen hergestellt. Zwischen Kühlmittel und Träger besteht keine Trennungslinie.

Der Träger kann auch wenigsten einen Hohlraum in Form eines Kanals aufweisen. Dieser Kanal bildet dann das Kühlmittel durch das Fluide (Gas, Wasser, Luft, etc.) fließt, wodurch das Modul gekühlt werden kann. Es handelt sich dann um eine Fluidkühlung bzw. um ein fluidgekühltes Modul.

Das Anschlussmittel ist bevorzugt über den AMB-Prozess mit dem keramischen Träger verbunden. Gerade der AMB Prozess ermöglicht es, einen keramischen Träger mit einem den Metallisierungsbereich und/ oder Träger überstehendes bzw. hinausragendes Anschlussmittel mit einer Materialdicke größer als 0,3 mm und/oder einer Entlastungszone zu verbinden. Dabei wird in einem Vakuum oder einer Inertgasatmosphäre, mittels einer Metalllotlegierung, einem Akivlot, Kupfer mit Keramik, beispielsweise AlSiC verbunden. Bevorzugt wird bei dem AMB-Verfahren mit einer Lotpaste gearbeitet, die zwischen 20-40 µm gedruckt vorliegt und somit eine Oberfläche gleichmäßig benetzt werden kann. Es hat sich herausgestellt, dass sich bei sorgfältiger Anwendung des AMB-Verfahrens keine Lunker bzw. Hohlräume zwischen der Keramik und dem Anschlussmittel bilden. Dadurch kann eine sichere und zuverlässige Verbindung zwischen Keramik und Anschlussmittel hergestellt werden. Die hohlraumfreie Verbindung zwischen Anschlussmittel und Keramik begünstigt den Wärmeübergang und somit den Wärmeabtransport mittels der Kühlmittel. Dadurch wird die Kühlleistung stark verbessert.

Die Verbindungen der elektronischen Komponenten, z.B. der Si/SiC-Chips innerhalb des Moduls mit dem Anschlussmittel kann mittels Bänder, so genannten "Ribbon bonding" erfolgen.

Ein erfindungsgemäßes Verfahren zur Herstellung eines erfindungsgemäßen Moduls wird durch die Merkmale des Verfahrensanspruchs 13 beschrieben. Es bezieht sich auf Module, an denen Spannungen größer als 1.000 V und Ströme größer als 100 A über Zuleitungen angelegt werden. Ein elektrisch isolierender Träger wird über ein Metallisierungsbereich mit einem Anschlussmittel, mit einer Materialdicke größer als 0,3 mm verbunden. Dadurch, dass das Anschlussmittel an zumindest einer Stelle seitlich oder in einem Winkel zumindest über den Metallisierungsbereich und/oder den Träger hinausgeführt wird, und wenigstens ein Kontaktelement aufweist sind für die Stromzuführung von außen an das Modul keine Bondprozesse mehr erforderlich. Es werden dadurch parasitäre Induktivitäten vermieden. Zusätzlich kann die Bauhöhe der Hochleistungsschaltung reduziert beziehungsweise verringert werden. Die bogenförmige Ausdehnung der Bonddrähte über die elektronischen Komponenten hinweg ist nicht mehr erforderlich. Das Anschlussmittel wird mittels eines Kontaktelements mit der Leistungsversorgung verbunden.

Bevorzugt wird als elektrisch isolierender Träger eine gesinterte Keramik verwendet und werden die Anschlussmittel über einen AMB-Prozess auf dem Metallisierungsbereich des Trägers fixiert. Die Vorteile des AMB-Verfahrens sind bei der Beschreibung der erfindungsgemäßen Module der Hochleistungsschaltung schon eingehend beschrieben worden.

Die Erfindung betrifft ein elektronisches Hochleistungsmodul bzw. deren Module, bei dem Spannungen größer als 1.000 V und Ströme größer als 100 A über Zuleitungen angelegt werden, mit einem elektrisch isolierenden Träger auf dem über ein Metallisierungsbereich ein Anschlussmittel mit einer Materialdicke größer als 0,3 mm fixiert ist und auf dem elektronische Komponenten angeordnet sind, die ja nach Bedarf mit dem Anschlussmittel elektrisch verbunden sind.

Damit die Stromzuführung von außen direkt an das Modul, an das Anschlussmittel erfolgt und somit die im Stand der Technik üblichen Bondprozesse entfallen und dadurch parasitäre Induktivitäten an der Stromzuführung vermieden werden, wird erfindungsgemäß vorgeschlagen, dass das Anschlussmittel an zumindest einer Stelle seitlich oder in einem Winkel zumindest über den Metallisierungsbereich hinausgeführt ist, in diesem Überstand nicht auf dem Träger fixiert ist und Kontaktmittel für die Zuleitungen aufweist.

Nachfolgend wird die Erfindung anhand von Figuren weiter erläutert. Alle Figuren enthalten ausschnittsweise, schematische Darstellungen der Erfindung und werden beispielhaft zur Erläuterung der Erfindung herangezogen. Spezielle Ausführungsformen der Erfindung können von diesen Figuren abweichen. Die Darstellung des erfindungsgemäßen Leistungsmoduls in den Figuren erfolgt skizzenhaft und in schematischer Weise.

### Dabei zeigt

- Figur 1:: einen Querschnitt eines erfindungsgemäßen Leistungsmoduls,
- Figur 2: die Draufsicht eines Leistungsmoduls gemäß Figur 1,
- Figur 3: eine spezielle Ausführung eines erfindungsgemäßen Leistungsmoduls,
- Figur 4: eine perspektivische Darstellung eines erfindungsgemäßen Leistungsmoduls mit einer thermischen Entlastungszone,
- Figur 5a, 5b, 5c: verschiedenen Ausführungen einer thermische Entlastungszone eines Leistungsmoduls gemäß Figur 4 und
- Figur 6: eine perspektivische Darstellung eines erfindungsgemäßen Leistungsmodus mit unterschiedlichen Ausprägungen der thermischen Entlastungszone und mit verschiedenen Kühlmitteln.

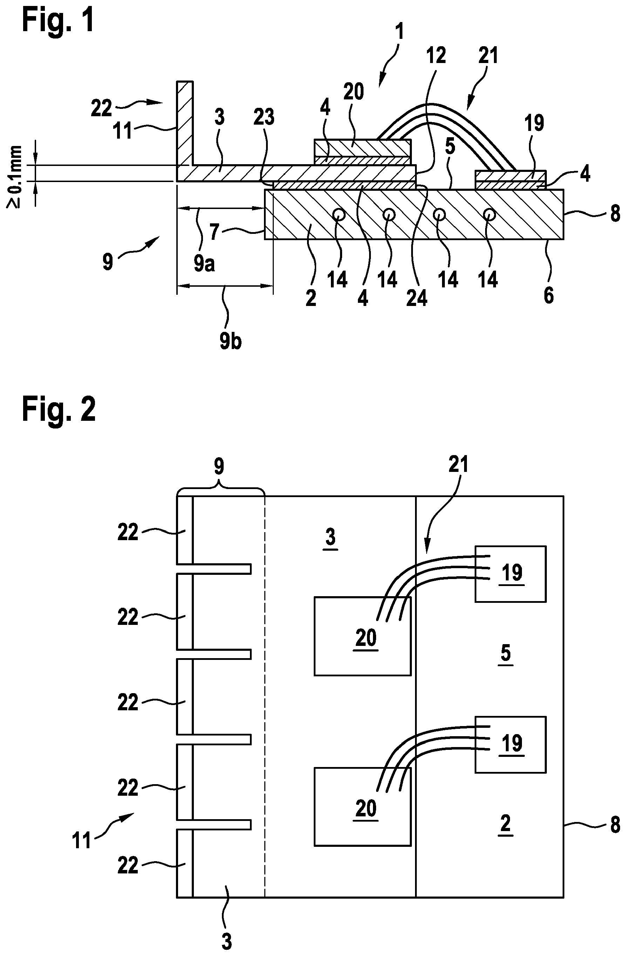

Figur 1 zeigt ein erfindungsgemäßes Leistungsmodul, ein Modul 1 mit einem Träger 2 einem Anschlussmittel 3, mit einer Höhe bzw. Materialdicke >= 0,3mm, welches über einen Metallisierungsbereich 4 mit dem Träger 2 verbunden ist. Der Träger 2 ist gemäß Figur 1 eine Platte mit den Maßen 7,5 Zoll ^{∗} 5,5 Zoll. Diese keramischen Platten werden auch als Substrate bezeichnet. Mit dem Träger 2 ist wiederum über einen Metallisierungsbereich 4 eine erste elektronische Komponente 19 beispielsweise ein Chip verbunden. Diese erste elektronische Komponente 19 ist mittels sogenannten Bonddrähten 21 mit einer zweiten Komponente 20 verbunden. Die zweite Komponente 20 ist über einen Metallisierungsbereich 4 an dem Anschlussmittel 3 angeordnet. Bei dem Träger 2 gemäß Figur 1 handelt es sich um einen keramischen Träger 2 in Form eines Quaders. Der Quader wird durch eine erste Flachseite 5 und eine zweite Flachseite 6 begrenzt. Der Abstand zwischen diesen beiden Flachseiten 5 und 6 bildet die Höhe des keramischen Trägers 2. In seitlicher Ausrichtung wird der Träger 2 durch vier Seitenflächen begrenzt. In Figur 1 ist die erste Seitenfläche 7 und die zweite Seitenfläche 8 erkennbar. Das Anschlussmittel 3 wird durch ein erstes Ende 11 und ein zweites Ende 12 begrenzt. Das zweite Ende 12 des Anschlussmittels 3 ist innerhalb eines Bereiches angeordnet, der durch die Seitenflächen des Trägers 2 gebildet ist. Das erste Ende 11 des Anschlussmittels 3 ist zum Träger 2 und zum Metallisierungsbereich 4, der ein erstes Ende 23 und ein zweites Ende 24 aufweist, im Abstand angeordnet. Der Abstand ist in Figur 1 als Überstand 9 ersichtlich. Dabei wird der Überstand 9a durch den Abstand zwischen dem ersten Ende 11 des Anschlussmittels 3 und der ersten Seitenfläche 7 des Trägers 2 gebildet. Der Überstand 9b ist der Abstand zwischen dem ersten Ende 11 des Anschlussmittels 3 und dem ersten Ende 23 des Metallisierungsbereichs 4. Am ersten Ende 11 des Anschlussmittels 3 ist ein Kontaktmittel 22 vorgesehen. Dieses Kontaktmittel 22 wird mit einer Leistungsversorgung (nicht dargestellt) verbunden. Dadurch kann das Leistungsmodul mit Strom und Spannung versorgt werden. Damit das Leistungsmodul 1 ausreichend gekühlt werden kann, weißt es Kühlkanäle 14 auf. Durch diese Kühlkanäle 14 können Fluide geleitet werden, um den Wärmeabtransport zu ermöglichen und zu verbessern.

Figur 2 zeigt die Draufsicht auf die erste Flachseite 5 des erfindungsgemäßen Moduls 1 nach Figur 1. Das Anschlussmittel 3, welches über den Metallisierungsbereich 4 mit dem Träger 2 verbunden ist, weißt fünf Kontaktmittel 22 auf. Zwischen den einzelnen Kontaktmitteln 22 ist ein Abstand, ein Spalt vorgesehen. Der Abstand ist so groß, dass beim Anlegen einer Spannung kein Funkenüberschlag zwischen zwei benachbart angeordneten Kontaktmitteln 22 stattfinden kann. Die Anzahl der Kontaktmittel 22 sowie deren Größe und Gestaltung ist abhängig von der Leistungsaufnahme des Moduls 1 und können an diese angepasst sein. Der Bereich, in dem das Anschlussmittel 3 den Träger 2 überragt ist mit dem Überstand 9 gezeigt. Zusätzlich zeigt Figur 2 beispielhaft erste und zweite elektronische Komponenten 19, 20. Die Verbindung zwischen den elektronischen Komponenten 19, 20 ist durch Bunddrähte 21 angedeutet. Der Übersichtlichkeit wegen sind jeweils nur 2 Bunddrähte 21 angedeutet. Tatsächlich werden eine Vielzahl dieser Bunddrähte 21 für die Verbindung zwischen den elektronischen Komponenten verwendet.

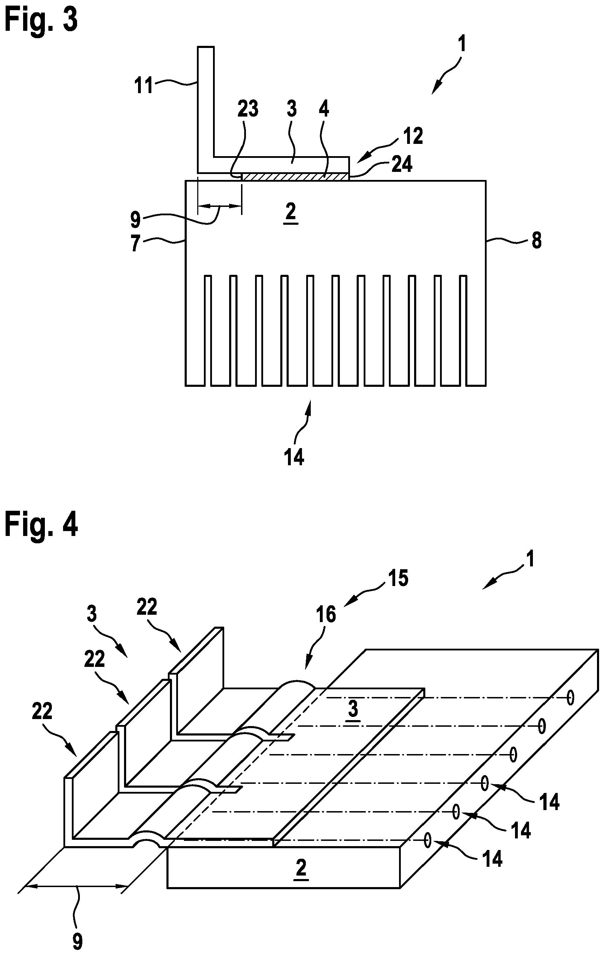

Figur 3 zeigt ein spezielles Ausführungsbeispiel eines erfindungsgemäßen Moduls 1. Dabei befinden sich sowohl das erste Ende 11 wie auch das zweite Ende 12 des Anschlussmittel 3 innerhalb des Bereiches, der von den Seitenflächen des Trägers 2 gebildet wird. Der Metallisierungsbereich 4 wird durch ein erstes Ende 23 und ein zweites Ende 24 begrenzt. Die Fläche des Anschlussmittels 3 die in Richtung des Trägers 2 angeordnet ist, ist größer als die Fläche des Metallisierungsbereichs 4 über die das Anschlussmittel 3 am Träger 2 verbunden ist. Der Überstand 9 wird durch den Abstand zwischen dem ersten Ende 11 des Anschlussmittels 3 und dem ersten Ende 23 des Metallisierungsbereichs 4 gebildet. Der keramische Träger 2 umfasst Kühlmittel 14 in Form von Finnen. Diese Kühlmittel 14 sind integraler Bestandteil des Trägers 2 und einstückig mit diesem verbunden. Zwischen den Kühlmitteln 14 und dem Träger 2 ist keine Trennungslinie vorhanden. Bei den Kühlmitteln 14 handelt es sich um einzelne Finnen die beabstandet zueinander angeordnet sind. Dadurch entstehenden Räume durch die Luft zirkulieren kann, wodurch die Kühlleistung erhöht wird.

Figur 4 zeigt ein erfindungsgemäßes Modul 1, wobei das Anschlussmittel 3 im Bereich des Überstands 9 eine Entlastungszone 15 mit Dehnungsmittel 16 aufweist. Diese Entlastungszone 15 ist so ausgebildet, dass sie Ausdehnungen kompensiert, die aufgrund des Leistungseintrags in das Modul und der damit verbundenen Wärmeentwicklung entstehen. Dadurch erhöht sich die Lebensdauer des Moduls 1. Die Entlastungszone 15 gemäß Figur 4 besteht aus rund geformten Abschnitten, welche die Dehnungsmittel 16 aufweisen. Die Dehnungsmittel 16 sind flexibel ausgebildet. Die Flexibilität kann dadurch erreicht werden, dass der Querschnitt dieser Abschnitte im Vergleich zum Querschnitt des Anschlussmittels 3 verringert ist. Zusätzlich sind aus Figur 4 Kühlmittel 14 in Form von Kühlkanälen ersichtlich. Diese Kühlmittel 14 in Figur 4 sind beispielhaft angedeutet. Sie können abhängig von der Anwendung des Moduls 1 variieren in deren Anordnung, Ausrichtung, Durchmesser, Größe und deren Verlauf.

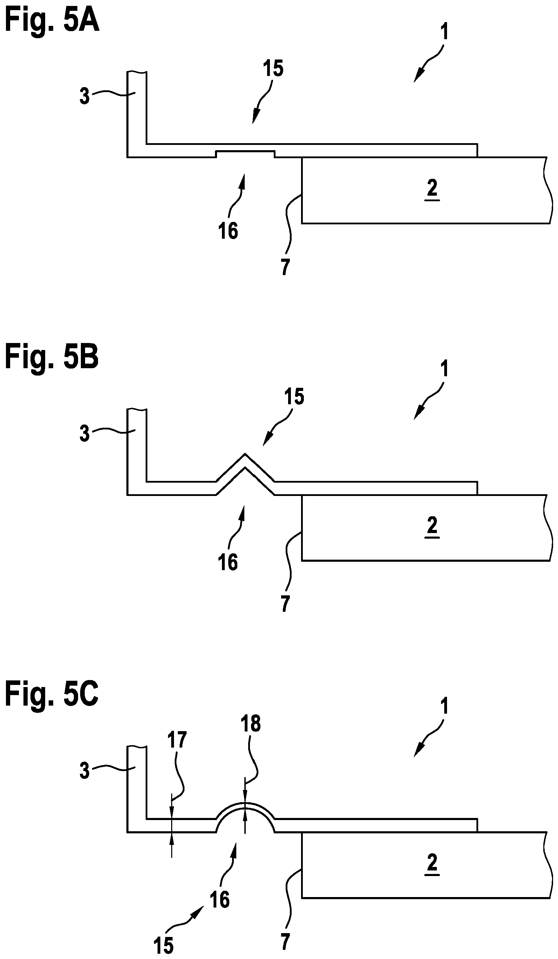

Aus den Figuren 5A, 5B und 5C sind verschieden geformte Dehnungsmittel 16 der Entlastungszone 15 ersichtlich. Dabei handelt es sich wie Figur 5A zeigt um eine Aussparung oder gemäß Figur 5B um eine winklig angeordnete flexible Zone, die in Form eines Dreiecks oder gemäß Figur 5C in Form eines gebogenen Abschnitts gebildet ist. Die Dehnungsmittel 16 können, um deren Flexibilität zu erhöhen, unabhängig ihrer Form niedrigere Querschnitte als das Anschlussmittel 3 aufweisen. In Figur 5C ist ersichtlich, dass die Höhe 18 bzw. Materialdicke des Dehnungsmittels 16 geringer ist als die Höhe 17 bzw. Materialdicke des Anschlussmittels 3. Alle diese unterschiedlich geformten Dehnungsmittel 16 haben gemeinsam, dass sie flexibel ausgebildet sind. Die Flexibilität kann durch die geometrische Form oder durch den beispielsweise verjüngten Querschnitt gebildet sein.

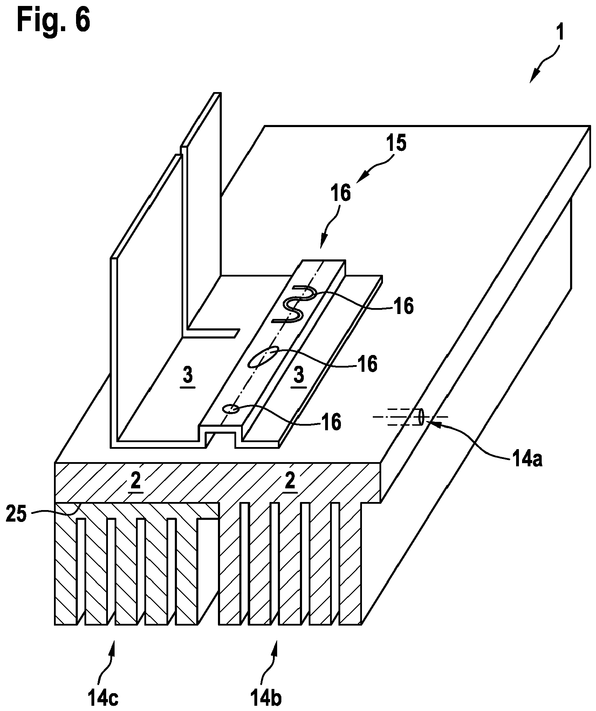

Figur 6 zeigt eine perspektivische Darstellung eines erfindungsgemäßen Moduls 1. Dabei sind an dem Träger 2 unterschiedliche Kühlmittel 14a, 14b, 14c angeordnet. Er weist ein Kühlmittel 14a in Form eines Kühlkanals wie auch in Figur 4 gezeigt auf. Zusätzlich weißt der Träger 2 ein Kühlmittel 14b wie in Figur 3 gezeigt auf. Dieses Kühlmittel ist integral mit dem Träger 2 verbunden. Zusätzlich ist aus Figur 6 erkennbar, dass ein Kühlmittel 14c mit dem Träger 2 verbunden ist. Bei dem Kühlmittel 14c handelt es sich um ein eigenständiges Mittel welches mit an sich bekannter Verbindungstechnik mit dem Träger 2 verbunden ist. Deshalb ist zwischen dem Kühlmittel 14c und dem Träger 2 eine Trennungslinie 25 erkennbar. Die in Figur 6 gezeigten verschiedenen Kühlmittel 14a, 14b, 14c können einzeln an einem Träger 2 oder in jeder beliebig vorstellbaren Kombination angeordnet sein.

Zusätzlich ist aus Figur 6 die Entlastungszone 15 zu erkennen. Diese Entlastungszone 15 weißt unterschiedlich gestaltete Dehnungsmittel 16 auf. Dabei handelt es sich um Aussparungen innerhalb der Entlastungszone 15 wodurch deren Flexibilität erhöht wird. Die Aussparungen können durch Bohrungen, Sackbohrungen oder Ausnehmungen mit beliebiger Form, beispielsweise elliptische Ausnehmungen oder Ausnehmungen mit freien Formen gebildet sein. Denkbar sind jegliche Kombinationen von Ausnehmungen innerhalb der Entlastungszone 15 mit denen die Flexibilität dieser Entlastungszone 15 erhöht wird.

In allen Figuren ist nicht gezeigt, dass die elektronische Hochleistungsschaltung mit einer nichtleitenden Vergussmasse vergossen sein kann. Ist dies der Fall ragen ausschließlich die Kontaktmittel 22 aus der Vergussmasse heraus und können mit einer externe Leistungsversorgung verbunden werden.

| | |
|---|---|
| 1 | Modul |
| 2 | Träger |
| 3 | Anschlussmittel |
| 4 | Metallisierungsbereich |
| 5 | erste Flachseite von 2 |
| 6 | zweite Flachseite von 2 |
| 7 | erste Seitenfläche von 2 |
| 8 | zweite Seitenfläche von 2 |
| 9, 9a, 9b | Überstand |
| 10 | Grundfläche von 3 |
| 11 | erstes Ende von 3 |
| 12 | zweites Ende von 3 |
| | |
| 14, 14a, 14b, | Kühlmittel |
| 15 | Entlastungszone |
| 16 | Dehnungsmittel |
| 17 | Höhe von 3 |
| 18 | Höhe von 16 |
| 19 | erste elektronische Komponente |
| 20 | zweite elektronische Komponente |
| 21 | Bonddraht |
| 22 | Kontaktmittel |
| 23 | erstes Ende von 4 |
| 24 | zweites Ende von 4 |
| 25 | Trennungslinie |

## Patentansprüche

1. Modul (1), bei dem Spannungen größer als 1.000 V und Ströme größer als 100 A über Zuleitungen angelegt werden,
- mit einem elektrisch isolierenden Träger (2),
- mit einem Anschlussmittel (3) mit einer Materialdicke größer als 0,3 mm, welches über einen Metallisierungsbereich (4), der von einem ersten Ende (23) und einem zweiten Ende (24) begrenzt ist, mit dem Träger (2) verbunden ist,
- mit elektronischen Komponenten (19, 20), die mit dem Anschlussmittel (3) je nach Bedarf elektrisch verbunden sind und
- mit Kühlmittel (14),
**dadurch gekennzeichnet, dass** das Anschlussmittel (3), bevorzugt Kupfer, an zumindest einer Stelle über ein Ende (23, 24) des Metallisierungsbereichs (4) ragt, und in diesem Bereich (9) nicht mit dem Träger (2) fixiert ist und Kontaktmittel (22) aufweist.

2. Modul nach Anspruch 1, **dadurch gekennzeichnet, dass** der Träger (2) durch Seitenflächen begrenzt ist und das Anschlussmittel (3) wenigstens eine Seitenfläche (7) des Trägers (2) überragt.

3. Modul nach Anspruch 1 oder 2, **dadurch gekennzeichnet, dass** das Anschlussmittel (3) wenigstens eine thermische Entlastungszone (15) aufweist.

4. Modul nach Anspruch 3, **dadurch gekennzeichnet, dass** die zumindest eine thermische Entlastungszone (15) außerhalb des Trägers (2) bevorzugt unmittelbar angrenzend an diesem angeordnet ist.

5. Modul nach einem der Ansprüche 3 und 4, **dadurch gekennzeichnet, dass** die zumindest eine thermische Entlastungszone (15) Dehnungsmittel (16) aufweist.

6. Modul nach Anspruch 5, **dadurch gekennzeichnet, dass** der Querschnitt des Dehnungsmittels (16) kleiner als der Querschnitt des Anschlussmittels (3) ist.

7. Modul nach Anspruch 5 oder 6, **dadurch gekennzeichnet, dass** die Dehnungsmittel (16) durch Öffnungen oder Materialausnehmungen gebildet werden.

8. Modul nach einem der Ansprüche 1 bis 7, **dadurch gekennzeichnet, dass** der elektrisch isolierende Träger (2) eine gesinterte Keramik ist.

9. Modul nach einem der Ansprüche 1 bis 8, **dadurch gekennzeichnet, dass** die Kühlmittel (14) des Trägers (2) durch Finnen gebildet sind.

10. Modul nach Anspruch 9, **dadurch gekennzeichnet, dass** die als Finnen ausgebildeten Kühlmittel (14) einstückig, ohne Trennungslinie mit dem Träger (2) verbunden sind.

11. Modul nach einem der Ansprüche 1 bis 8, **dadurch gekennzeichnet, dass** die Kühlmittel (14) des Trägers (2) durch Hohlräume gebildet sind.

12. Modul nach einem der Ansprüche 1 bis 11, **dadurch gekennzeichnet, dass** das Anschlussmittel (3) über einen AMB-Prozess mit dem Träger (2) stoffschlüssig verbunden ist.

13. Verfahren zur Herstellung eines elektronischen Hochleistungs-Moduls, das mit Spannungen größer als 1.000 V und Ströme größer als 100 A über Zuleitungen versorgt wird, mit einem elektrisch isolierenden keramischen Träger (2) auf dem mittels eines Metallisierungsbereichs (4) ein Anschlussmittel (3) mit einer Dicke größer als 0,3 mm fixiert wird, und auf dem Träger (2) elektronische Komponenten (20, 19) angeordnet werden, die mit dem Anschlussmittel (3) je nach Bedarf elektrisch verbunden werden, **dadurch gekennzeichnet, dass** das Anschlussmittel (3) an zumindest einer Stelle seitlich oder in einem Winkel zumindest über den Metallisierungsbereich (4) hinausgeführt wird, in diesem Überstand (9) nicht auf dem Träger (1) fixiert ist und Anschlusslaschen (22) für eine Zuleitung aufweist.

14. Verfahren nach Anspruch 13, **dadurch gekennzeichnet, dass** der elektrisch isolierende Träger (2) eine gesinterte Keramik ist und die Anschlussmittel (3) über einen AMB-Prozess mit Aktivlot (4) auf dem Metallisierungsbereich (4) des Trägers (2) fixiert werden.

15. Verfahren nach Anspruch 13 oder 14, **dadurch gekennzeichnet, dass** als Aktivlot (4) eine Lotpaste verwendet wird, die als Platte mit einer Dicke zwischen 20-40 µm gedruckt vorliegt.
